# EUROPEAN PATENT APPLICATION

(11) **EP 3 393 042 A1**
(43) Date of publication of application: **24.10.2018**
(21) Application number: 18166010.1
(22) Date of filing: 06.04.2018
(51) Int. Cl.: H03K 17/687, H03K 17/693, G06F 13/40

(54) **ELECTRONIC APPARATUS HAVING A SERIAL AND DIGITAL TRANSMISSION OUTPUT AND DEVICE FOR MEASURING ELECTRIC QUANTITIES COMPRISING SAID ELECTRONIC APPARATUS**

(30) Priority: 19.04.2017 IT 201700043020
(71) Applicant: D.E.M. S.p.A., 32013 Longarone, (BL) (IT)
(72) Inventor: Berton, Mattia, 32013 Longarone BL (IT)
(74) Representative: Perani & Partners S.p.A.

(57) **Abstract**

The present disclosure relates to an electronic apparatus (1) having a serial and digital transmission output which comprises a processing unit (2), an output clamp (3) comprising first, second and third output terminals (31, 32, 33), said first terminal being an output terminal configured to emit a digital signal (Digit); a serial line (4), comprising first and second serial data lines (41,42) and a ground line (43). The electronic apparatus (1) is characterized by comprising a switch device (5), in signal communication with said processing unit (2), said switch device (5) comprising a first electronic switch (6) and a second electronic switch (7), wherein one end of said first electronic switch (6) is electrically connected with a first serial data line (41) and the other end of said first electronic switch (6) is electrically connected with said first terminal (31) of said output clamp (3), wherein one end of said second electronic switch (7) is electrically connected with the end of the first electronic switch (6) that is electrically connected with said first terminal (31) of the output clamp (3) and the other end of said second electronic switch (7) is electrically connected with said third terminal (33) of said output clamp (3), said second serial data line (42) is electrically connected with said second terminal (32) of said output clamp (3), said ground line (43) is electrically connected with said third terminal (33) of said output clamp (3),
- said processing unit (2) generates a control signal (V) which is configured:
- to cause said first electronic switch (6) to switch to the closed configuration and to cause the second electronic switch (7) to switch to the open configuration, so that said first line (41) of the serial line (4) will be on the first terminal (31) of the output clamp (3);
- to cause said first electronic switch (6) to switch to the open configuration and to cause the second electronic switch (7) to switch to the open or closed configuration, so that said digital signal (Digit) will be on said first terminal (31) of the output clamp (3) in the open or closed state respectively.

## Description

### FIELD OF THE INVENTION

The present disclosure relates to an electronic apparatus having a serial and digital transmission output as defined in the preamble of claim 1.

Namely, the present disclosure relates to an electronic apparatus having an output clamp that can have both digital and serial signals on its terminals.

The present disclosure also relates to a device for measuring electric quantities, and particularly the Alternating Current and the AC voltage at its terminals, which comprises an electronic apparatus having a serial and digital transmission output at its clamp.

### Discussion of the related art

Electronic devices are employed in the prior art, which provide a digital or serial signal at their output. Namely, these devices have a processing unit that generates a signal which, when suitably processed, is output from the device by digital signal transmission on an output clamp thereof or by serial protocol transmission on a serial port, hence on an output clamp other than the digital one.

For instance, one of these devices is a network analyzer that can measure electric quantities using special electric quantity transducers. This prior art network analyzer is configured to receive either an AC voltage or an AC current at its clamp, according to the hardware configuration of the network analyzer, and to use an ADC converter to convert it into an output signal to be provided to a microcontroller which in turn processes it to measure the detected electric quantities.

The measurement signal so processed by the microcontroller is provided, for instance, to a PLC or a PC via the serial port (e.g. a RS485 port), whereas other digital signals, such as alarm signals, are provided on a digital output clamp which is different from the serial port.

WO 96/17305 A2 discloses an electronic apparatus configured to connect serial devices of the same bus together. This document discloses a circuit that allows data communication among sub-circuits incorporated in integrated circuits that operate with different power voltages. Namely, a third BUS line is interposed between first and second BUS lines. The third BUS line is interconnected with the first BUS line via a first field effect transistor (MOSFET), where a first diode is connected in parallel to the channel of the first transistor. The third BUS line is connected with the second BUS line via a second transistor, where a second diode is connected in parallel to the channel of the second transistor. The provision of the two transistors can stop the I2C serial communication between the devices.

US 6,857,039 discloses a bidirectional BUS circuit that is used for a microprocessor and is configured for stable high-speed bidirectional data transmission. Particularly, the circuit as disclosed therein can prevent the potential level of the bus from being free to fluctuate, when the bus is not being used.

### Prior art problem

Therefore, the electronic devices of the prior art suffer from the drawback of requiring distinct output clamps for what is transmitted with a serial protocol and what is available in digital form.

The need for two output clamps involves the implementation of two clamps, one for the serial protocol and the other for the digital signal, as well as the use of two optoisolators for galvanic isolation of the transmission circuit from the rest of the circuitry of the device.

Especially in network analyzers or in electric quantity measuring devices in general, reinforced isolation must be maintained between the electric quantity measuring circuit and the transmission circuit that outputs the measurement signals from the device to avoid noise.

Therefore, prior art electronic apparatus have separate circuits and outputs on distinct clamps for communication with the different digital and serial protocols, which leads to an increase of manufacturing costs, implementation complexity and physical dimensions of the apparatus, resulting in a greater number of switchboard slots being taken.

### SUMMARY OF THE INVENTION

The object of the present invention is to provide an electronic apparatus that can obviate the drawbacks of the prior art.

This object is fulfilled by an electronic apparatus having a serial and digital transmission output, and by a device for measuring electric quantities as defined by the features of the claims as set forth below.

### Advantages of the Invention

One embodiment can provide an electronic apparatus that can generate both a digital and a serial output signals on the same clamp.

One embodiment can provide an electronic apparatus that has a smaller size than those of the prior art, as the electronic apparatus employs a smaller number of output ports.

Namely, WO 96/17305 and US 6,857,039 do not teach or suggest, alone or in combination, a circuit configuration that can provide a serial transmission or a digital signal on the same data line.

### BRIEF DETAILS OF THE DRAWINGS

The characteristics and advantages of the present disclosure will appear from the following detailed description of a possible practical embodiment, illustrated as a nonlimiting example in the set of drawings, in which:
- Figure 1 shows a block diagram of an electronic apparatus with a digital and serial transmission output according to the present invention,
- Figure 2 shows the block diagram of the apparatus of Figure 1 in greater detail,
- Figure 3 shows a preferred embodiment of the electronic apparatus of Figure 2.

### DETAILED DESCRIPTION

Even when this is not expressly stated, the individual features as described with reference to the particular embodiments shall be intended as auxiliary to and/or interchangeable with other features described with reference to other exemplary embodiments.

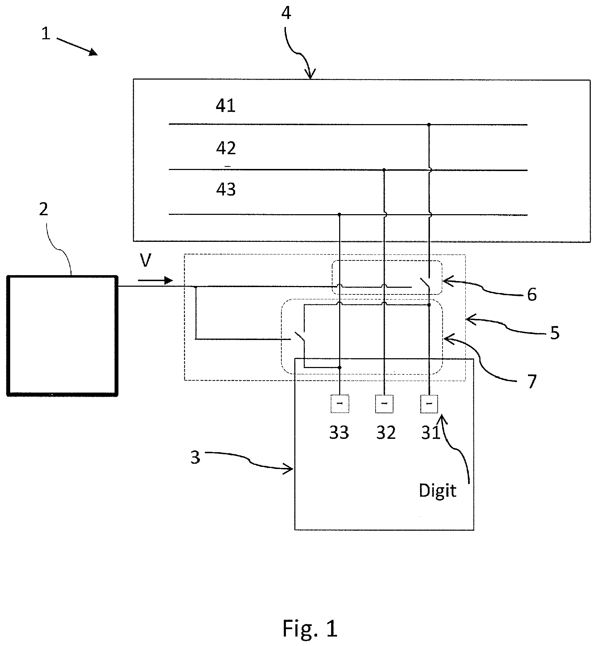

The present invention relates to an electronic apparatus having a serial and digital transmission output, which is generally designated by numeral 1 in the annexed figures 1 to 3.

The electronic apparatus 1 comprises a processing unit 2 in signal communication with a switch device 5 for connecting a serial line 4 with an output clamp 3 such that either the digital signal or the serial signal of the serial line 4 may be found on the output clamp 3.

Namely, in a peculiar aspect, the processing unit 2 of the electronic apparatus 1 generates a control signal V upon an operator's request, which signal suitably controls the switch device 5 to cause either a digital signal or the serial signals of the serial line 4 to be provided to the clamp 3.

Since the output clamp 3 must be able to also have the signals on the serial line 4 at its output, in addition to its digital signal Digit, then the output clamp 3 must comprise as many terminals 31, 32 and 33 as the lines 41, 42, 43 of the serial line 4.

Particularly, the serial line 4 is of the RS485 type with Modibus protocol and comprises, for instance, three lines 41, 42, 43, with the first data line 41 representing a first serial signal A, the second data line 42 representing a first serial signal B and the third line 43 representing the ground.

Due to the foregoing, the output clamp 3 also comprises three terminals 31, 32 and 33, each being connected or able to be connected to a respective line 41, 42, 43 of the serial line 4.

In order to suitably control the switch device 5 for either the digital signal Digit or the signals of the serial line 4 to be available to the clamp 3, such switch device 5 comprises two electronic switches 6, 7 which are conveniently controlled by the processing unit 2 to electrically connect or disconnect the serial line 4 from one of the terminals of the output clamp 3.

Particularly, according to a possible wiring diagram, with the terminal 31 being identified as the output terminal for the digital signal Digit, then such terminal 31 is adapted to be connected to / disconnected from the first data line 41 by the switch 6, whereas the other terminals 32, 33 are connected with the second data line 42 and the ground line 43 respectively, whereas the switch 7 connects/disconnects the terminal 31 to/from the terminal 33 of the output clamp 3.

The processing unit 2 is designed to generate the control signal V to connect/disconnect the terminal 31 to/from the first data line 41 using the switch 6 and to connect/disconnect the terminal 31 to/from the terminal 33 of the output clamp 3 using he switch 7.

In other words, the control signal V either isolates one of the terminals of the clamp 3, e.g. the one referenced 31, so that the digital signal Digit will be only found on such terminal or connects the terminal of the clamp 3 to the data line 41 of the serial line 4.

Particularly, one end of the first electronic switch 6 is designed to be electrically connected with the first line 41 of the serial line 4, and the other end of the first electronic switch 6 is designed to be electrically connected with the first terminal 31 of the output clamp 31, whereas one end of the second electronic switch 7 is designed to be electrically connected with the third terminal 33 of the output clamp 3 and the other end of the second electronic switch 7 is designed to be electrically connected with the end of the first electronic switch 6 that is electrically connected with the first terminal 31 of the output clamp 3.

Therefore, the first electronic switch 6 is operably controlled by the processing unit 2 by means of the control signal V to switch between an open configuration in which it prevents signal communication between the first line 41 of the serial line 4 and the first terminal 31 of the output clamp 3, and a closed configuration in which it allows signal communication between the first line 41 of the serial line 4 and the first terminal 31 of the output clamp 3.

Conversely, the second electronic switch 7 is operably controlled by the processing unit 2 by means of the control signal V to switch between an open configuration in which it prevents signal communication between the two terminals of the output clamp 3, and a closed configuration in which it allows signal communication between the two terminals 31, 33 of the output clamp 3.

In other words, the control signal V is configured:
- to cause the first electronic switch 6 to switch to the closed configuration and to cause the second electronic switch 7 to switch to the open configuration, so that the first line 41 of the serial line 4 will be emitted at the first terminal 31 of the output clamp 3;
- to cause the first electronic switch 6 to switch to the open configuration and to cause the second electronic switch 7 to switch to the open configuration, so that the digital signal will be emitted at the terminal 31 of the output clamp 3 in the open state;
- to cause the first electronic switch 6 to switch to the open configuration and to cause the second electronic switch 7 to switch to the closed configuration, so that the digital signal will be emitted at the terminal 31 of the output clamp 3 in the closed state;

According to a preferred embodiment:
- the first electronic switch 6 comprises two antiserially-connected N-type Mosfet transistors 8, 9 which are powered with a floating voltage;
- the second electronic switch 7 comprises a N-type Mosfet transistor 10 which is powered with a DC voltage.

As used herein, the term N-type Mosfet transistor is intended to designate a N-MOS transistor of known type in which current enters the drain and exits from the source. In addition, as used herein, an antiserial connection is intended to indicate, like in the prior art, a serial connection (i.e. the connection mode in which one connection point is only provided between two parts), in which the polarities of the terminals are coupled by equal signs.

The processing unit 2 is configured to generate the control signal V as an PWM (Pulse-Width modulation) AC voltage signal for controlling the floating voltage between the gate and the source of two Mosfet transistors 8, 9 to thereby cause the first electronic switch 6 to switch between the open configuration and the closed configuration and is configured to generate the DC voltage control signal V, to thereby cause the second electronic switch 7 to switch between the open configuration and the closed configuration.

It shall be noted that, when the processing unit 2 generates an PWM AC voltage control signal V, the first electronic switch 6 is switched on and may switch between the open and closed configurations, whereas the second electronic switch 7 is switched off and is in the open configuration.

Conversely, when the processing unit 2 generates a DC voltage control signal V, the second electronic switch 7 is switched on and may switch between the open and closed configurations, whereas the first electronic switch 6 is switched off and is in the open configuration.

As two Mosfet transistors 8, 9 are driven, i.e the first electronic switch 6 is switched on, the processing unit 2 is configured to generate:
- the PWM control signal V with a preset duty cycle frequency, to set the voltage between the gate and source electrodes Vgs of the two antiserially connected Mosfet transistors 8, 9 to at least 2.5 V, to thereby switch the first electronic switch 6 to the closed configuration;
- the PWM control signal V to set the voltage between the gate and source electrodes Vgs of the two antiserially connected Mosfet transistors 8, 9 to 0 V, to thereby switch the first electronic switch 6 to the open configuration.

Also preferably, the processing unit 2 is configured to generate the PWM control signal V with a duty cycle frequency of at least 10%.

Preferably, the first electronic switch 6 comprises a charge pump 11, in signal communication with the processing unit 2.

In one aspect, the processing unit 2 comprises a microcontroller which is configured to generate the PWM control signal V at a preset frequency of at least 100 kHz to control the charge pump 11 that will generate the floating voltage, so that the voltage between the gate and the source of the two Mosfet transistors 8, 9 will be at least 2.5 V.

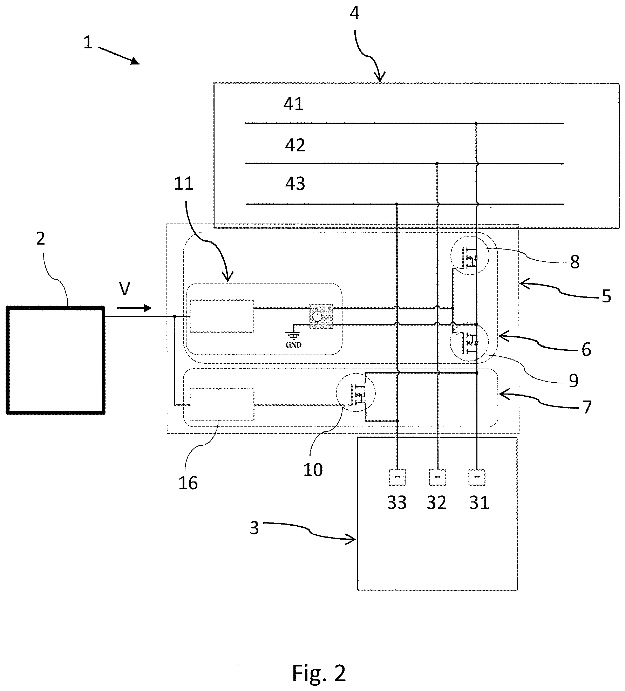

Referring to Figure 2, which shows a preferred embodiment, it shall be noted that the sources of the two Mosfet transistors 8, 9 are electrically connected to each other, with the drain of the first Mosfet transistor 8 electrically connected with the first line 41 of the serial line 4, and the drain of the second Mosfet transistor 9 electrically connected with the first terminal 31 of the output clamp 3. The gates of the two Mosfet transistors 8, 9 are electrically connected with the charge pump 11.

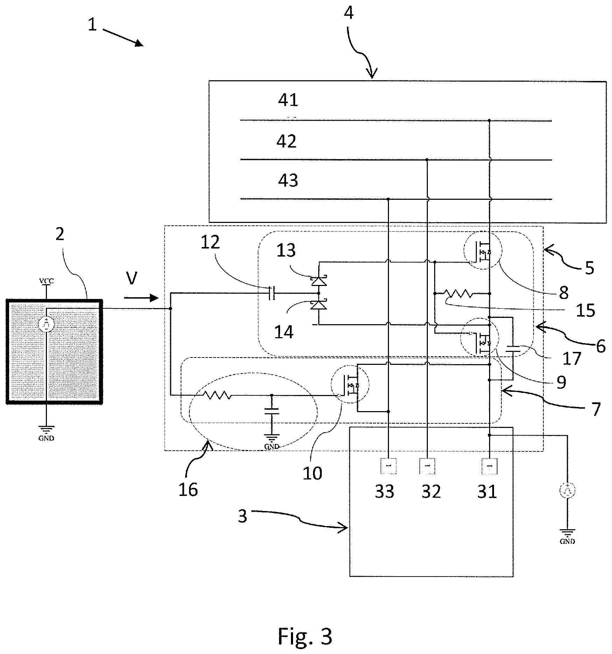

Referring now to Figure 3, it shall be noted that the charge pump 11 comprises a capacitor 12 having one end electrically connected with the processing unit 2 to receive the control signal V. The charge pump 11 also comprises two serially connected diodes 13, 14, whose joint end of the series of the two diodes 13, 14 is connected with the other end of the capacitor 12. On the other hand, the other end of a first 13 of the two diodes is electrically connected with the gates of the two Mosfet transistors 8, 9 and the other end of the second 14 of the two diodes is electrically connected with the source of the two Mosfet transistors 8, 9. The charge pump 11 comprises a resistor 15, which is connected in parallel to the series of the two diodes 13, 14 and has one end electrically connected with the gates of the two Mosfet transistors 8, 9 and the other end electrically connected with the sources of the two Mosfet transistors 8, 9.

In the exemplary embodiment as shown in Figure 3, a parasitic capacitor 17 is inevitably present in the circuit, with its ends electrically connected with the source and the drain of the second Mosfet transistor 14, because the signal is at a high frequency, of about 115 KHz, on the first terminal 31 of the output clamp. The first terminal 31 of the output clamp 3 will be switched to this frequency in the wost case. If the first electronic switch 6 is open, the voltage Vgs at the ends of the resistor 15 is close to 0 V and the voltage of the control signal V at the output of the processing unit (e.g. a microcontroller) is 0V. Nevertheless, the system composed of the parasitic capacitor 17, the capacitor 12 and the two diodes 13 acts in turn as a charge pump which tends to build up the voltage Vgs. This voltage is more quickly built up in proportion to the capacitance values of the capacitor 12, the parasitic capacitor 17 and the resistor 15. Therefore the capacitance of the capacitor 12 and the parasitic capacitor 17 should be minimized, preferably by also reducing the value of the resistor 15, to allow the first electronic switch 6 to operate.

Considering now the second electronic switch 7, also referring to Figure 3, it comprises a RC circuit 16 which comprises at least one resistor and a one capacitor connected in series.

The RC circuit 16 is configured to filter the DC voltage control signal V to generate an average value of DC voltage to be provided to the Mosfet transistor 10.

The second electronic switch 7 is configured to switch to the open configuration when the average voltage value supplied by the RC circuit 16 to the Mosfet transistor 10 is lower than a default threshold value depending on the same Mosfet transistor 10. As the second electronic switch 7 is opened and closed, the digital output on the output 3 clamp 3, is brought in the open and closed state respectively, thereby affording transmission of th digital signal.

Furthermore, the second electronic switch 7 is configured to switch to the closed configuration when the average voltage value is higher than the threshold value associated with the Mosfet transistor 10.

In a preferred embodiment, the RC circuit 16 forms a low-pass filter.

Still referring to Figure 3, an exemplary embodiment is shown in which the source of the Mosfet transistor 10 is electrically connected with the third terminal 33 of the output clamp 3, whereas the drain is electrically connected with the first terminal of the output clamp 3. The gate of the Mosfet transistor 10 is electrically connected with the RC circuit 16.

Furthermore, Figure 3 shows that:
- the third terminal 33 of the output clamp 3 is electrically connected with the corresponding line 43, which represents the ground GND of the serial line 4;
- the second terminal 32 of the output clamp 3 is electrically connected with the seconds line 42, which represents the data line B of the serial line 4.

Advantageously, the electronic apparatus so obtained can be smaller than those of the prior art, as it can have both the digital signal Digit and the data lines 41, 42, 43 of the serial line 4 on the terminals 31, 32 and 33 of a single output clamp 3.

Advantageously, a serial signal or a digital signal transmission may be provided on the same line of the N-type Mosfet transistor.

Advantageously, the signal that controls the switch composed of the antiserially-connected transistor is the same signal that controls the digital signal. In other words, one pin may be used to carry out two actions: stop serial communication and act on the digital signal. Furthermore, the signal that acts on the switch is floating relative to the ground, whereby the communication of high voltage serial signals can be stopped.

The present invention also relates to a device for measuring electric quantities, not shown. The device for measuring electric quantities comprises an electronic apparatus 1 of the present invention, for implementing the emission of an output signal from the device by serial or digital transmission.

An exemplary embodiment of a device for measuring electric quantities will be described hereinafter, which comprises an electronic apparatus 1, for the device to be able to output either a digital signal or a serial-protocol signal on the same output clamp 3. The output signal concerns one or more electric quantities as measured by the same device.

Particularly, according to a preferred embodiment, the device for measuring electric quantities is a three-phase network analyzer, or energy meter.

The device for measuring electric quantities comprises two input clamps which are adapted to be electrically connected with two respective output clamps of an electric quantity transducer.

The two input clamps are configured to receive an AC current or an AC voltage at their input.

The electric quantity transducer is a device configured to detect an electric quantity and generate an output current or voltage signal whose intensity is a function of the intensity of the physical quantity that has been detected.

For example, the electric quantity transducer may be a current sensor configured to sense the intensity of the alternating current that flows in a conductor, to thereby generate an output AC current or AC voltage signal whose intensity is proportional to electric current value that has been detected by the sensor.

In other words, AC current and AC voltage are the two signals that may be alternately found at the input of the clamps of the device for measuring electric quantities.

In one aspect, these two signals may be used to take measurements and make calculations as is usual in a device for measuring electric quantities, such as a network analyzer that is configured to calculate electric quantities including active power, apparent power, reactive power, frequency, and energy.

The device for measuring electric quantities comprises a processing unit, preferably the same as the processing unit 2 of the electronic apparatus 1, which is electrically connected with the two input clamps, and is configured to generate at least one electric quantity measuring signal related to the AC current or the AC voltage at the input of the two input terminals. Using a processing unit 2 with a single microcontroller, the manufacturing costs and the dimensions of the device for measuring electric quantities may be reduced.

The device for measuring electric quantities also comprises a switch device whose ends are electrically connected with two input clamps

The switch device comprises an electronic switch and resistive means connected in series. One end of the electronic switch is electrically connected with one of the two input clamps, whereas one end of the resistive means is electrically connected with the other of the two input clamps.

The electronic switch is operatively configured to switch between an open configuration in which it prevents the passage of electric current between the two input clamps and a closed configuration in which it allows the passage of electric current between the two input clamps.

Preferably, the resistive means comprise a single resistive element or a plurality of electrically connected resistive elements, for example connected in series.

Preferably, the switch device is configured to have at least 6 ampere of alternating current flow through the series of the electronic switch and the resistive means, when the electronic switch is in the closed configuration.

The processing unit is electrically connected with the two clamps and, as a result, with the ends of the switch device.

In one aspect, the processing unit is connected to the ground via a ground terminal GND and to a power supply voltage via the terminal Vdc.

Advantageously, the processing unit is configured to detect a potential difference value at the two input clamps and, according to the detected potential difference value, the processing unit is configured to cause the electronic switch to switch to the open configuration when it detects that the two clamps receive the AC voltage at their inputs, and to cause the electronic switch to switch to the closed configuration when it detects that the two clamps receive the AC current (I) at their inputs.

Namely, the processing unit is configured to recognize, according to the potential difference value detected at the two clamps, if an AC voltage or an AC current value is being provided at its input by the electric quantity transducer. Once the type of input signal has been detected, the processing unit causes the electronic switch to switch between the open and closed configurations.

In other words, if an electric quantity transducer that generates an output AC voltage is connected to the two clamps, the processing unit will cause the electronic switch to switch to the open configuration. Thus, in the open configuration of the electronic switch, the potential difference value at the two clamps 2 is substantially the same as the AC voltage value.

On the other hand, if an electric quantity transducer that generates an output AC current is connected to the two clamps, the processing unit will cause the electronic switch to switch to the closed configuration. In the closed configuration of the electronic switch, the AC current flows between the two clamps, also through the resistive means. Therefore, in the closed configuration, the AC current flows through the resistive means and generates a potential difference value at the two clamps that is a function of the intensity of the AC current and of the impedance value of the resistive means.

In a preferred arrangement of the invention, the electronic switch comprises two antiserially-connected N-type Mosfet transistors 8, 9 which are powered with a floating voltage;

The processing unit is configured to control the floating voltage between the gate and the source of the two Mosfet transistors, thereby causing the electronic switch to switch between the open configuration and the closed configuration. With this configuration, the alternating current at 50/60 Hz can be blocked if the potential difference between the gate and the source is zero (i.e., Vgs=0). It shall be noted that the N-type Mosfet transistors have a very low resistance (i.e. Rds_on).

Preferably, the electronic switch comprises a charge pump in signal communication with the processing unit to set the voltage between the gate and source electrodes Vgs of the two antiserially-connected Mosfet transistors at least to 5V.

The processing unit is configured to generate a PWM (Pulse Width Modulation) control signal with a preset duty cycle frequency.

In one aspect, the processing unit comprises an ADC converter, connected with the two input clamps, and hence also with the ends of the switch device.

Thus, the potential difference value at the two input clamps is received by the ADC converter, which generates an output signal according to such voltage value.

Furthermore, the processing unit also comprises a microcontroller in signal communication with the ADC converter and configured to process the output signal to thereby generate at least one electric quantity measuring signal.

Preferably, the microcontroller is in signal communication with the electronic switch, and is configured to control the electronic switch to cause it to switch to the open configuration when the two clamps receive the AC voltage at their inputs or to cause it to switch to the closed configuration when the two clamps receive the AC current at their inputs.

It shall be noted that the detection of the potential difference value at the two input clamps, which later allows the microcontroller to control the operation of the electronic switch, is carried out by the ADC converter. Thus, the ADC converter reads the potential difference value at the two input clamps and generates an output signal according to the detected value. This signal is processed by the microcontroller which both generates an electric quantity measuring signal and recognizes the type of the input signal at the two clamps.

Thus, the microcontroller can detect whether there is an AC voltage or an AC current at the input of the two clamps.

According to a preferred arrangement of the invention, the microcontroller is configured to generate the PWM control signal at a preset frequency of about 100 kHz, to control the charge pump. Accordingly, the charge pump generates the fluctuating voltage, and sets the voltage between the gate and the source (i.e. Vgs) of the two Mosfet transistors to a value of at least 5 V, which is required to maintain the Rds on of the Mosfet transistors low enough to avoid overheating of the same Mosfet transistors with 6 ampere of alternating current flowing therethrough.

The microcontroller is configured to switch the electronic switch to the open configuration when the potential difference value between one of the two clamps and the ground GND of the processing unit has a negative sign.

According to a further preferred embodiment, the device for measuring electric quantities is a three-phase network analyzer, and comprises three pairs of input clamps, wherein each pair of terminals are adapted to be electrically connected with two respective output of an electric quantity transducer to receive an AC current I or an AC voltage at its input. The device for measuring electric quantities comprises three respective switch devices, each electrically connected at its ends with a respective pair of input clamps. The processing unit comprises three ADC converters, each comprising two electric terminals electrically connected with a respective pair of input clamps to detect the potential difference value at the respective pair of input clamps, to thereby generate an output signal. The microcontroller in signal communication with the three ADC converters and configured to process the output signals to thereby generate at least one electric quantity measuring signal. The microcontroller is in signal communication with each electronic switch, and is configured to control each electronic switch to cause it to switch to the open configuration when the respective pair of input clamps receive the AC voltage. Conversely, the microcontroller is configured to control each electronic switch to cause it to switch to the closed configuration when the respective pair of clamps receive the AC current at their inputs. Preferably, in this preferred embodiment, the electric quantity transducers are electric current sensors. More preferably, the type of electric quantity transducer is chosen according to the particular installation and may be selected in the microcontroller via suitable software.

Concerning the electric quantity transducer (e.g. a current sensor), its output terminals are designed to be electrically connected to the two input clamps.

Preferably, if the device for measuring electric quantities comprises multiple pairs of input clamps, as is the case, for example, of a network analyzer, then the same device comprises as many electric quantity transducers, each electrically connected with a respective pair of input clamps.

According to a preferred embodiment of the invention, the device for measuring electric quantities comprises a serial port, preferably a ModBus RS485 port, to provide the electric quantity measuring signal generated by the microcontroller at its output. Preferably, the microcontroller firmware also manages ModBus RS485 communication, allowing data exchange with external devices.Advantageously, the present invention provides a device for measuring electric quantities that can receive both an AC current signal and an AC voltage signal at its input on the same pair of clamps.

Advantageously, the device for measuring electric quantities so obtained has a smaller size because both AC current and AC voltage measurements may be taken on the same pair of input clamps. Also, advantages may be derived from the possibility of installing the device for measuring electric quantities in a small container (e.g. 1 Din) with a smaller number of clamps.

Advantageously, the device for measuring electric quantities so obtained affords a reduction of manufacturing costs, due to the possibility of reducing the umber of electronic parts to be used. For instance, since the present invention allows both AC voltage and AC current measurements to be taken on the same pair of clamps, a single ADC converter may be used, instead of the two ADC converters required in the prior art. Furthermore, instead of using two devices to measure two electric quantities, i.e. one with an AC voltage input and the other with the AC current input, a single device may be used to alternately take AC current and AC voltage measurements.

Advantageously, the device for measuring electric quantities so obtained affords a reduction of power consumption, as it uses a smaller number of electronic parts to take as many measurements.

Advantageously, a network analyzer device may be provided, e.g. for analyzing three-phase networks, that can take alternating current measurements by receiving either an AC current signal or an AC voltage current at its input on the same pair of clamps.

Those skilled in the art will obviously appreciate that a number of changes and variants as described above may be made to fulfill particular requirements, without departure from the scope of the invention, as defined in the following claims.

## Claims

1. An electronic apparatus (1) having a serial and digital transmission output, comprising
- a processing unit (2);
- an output clamp (3) comprising first, second and third output terminals (31, 32, 33), said first terminal (31) being an output terminal configured to emit a digital signal (Digit);
- a serial line (4) comprising first and second serial data lines (41, 42) and a ground line (43),
**characterized in that it comprises:**
- a switch device (5) in signal communication with said processing unit (2), said switch device (5) comprising a first electronic switch (6) and a second electronic switch (7),
- wherein one end of said first electronic switch (6) is electrically connected with a first serial data line (41) and the other end of said first electronic switch (6) is electrically connected with said first terminal (31) of said output clamp (3),
- wherein one end of said second electronic switch (7) is electrically connected with the end of the first electronic switch (6) that is electrically connected with said first terminal (31) of the output clamp (3) and the other end of said second electronic switch (7) is electrically connected with said third terminal (33) of said output clamp (3),
- said second serial data line (42) is electrically connected with said second terminal (32) of said output clamp (3),
- said ground line (43) is electrically connected with said third terminal (33) of said output clamp (3),
- said processing unit (2) generates a control signal (V) which is configured:
- to cause said first electronic switch (6) to switch to the closed configuration and to cause the second electronic switch (7) to switch to the open configuration, so that said first line (41) of the serial line (4) will be on the first terminal (31) of the output clamp (3);
- to cause said first electronic switch (6) to switch to the open configuration and to cause the second electronic switch (7) to switch to the open or closed configuration, so that said digital signal (Digit) will be on said first terminal (31) of the output clamp (3) in the open or closed state respectively.

2. An electronic apparatus (1) as claimed in claim 1, wherein
- said first electronic switch (6) comprises two antiserially-connected N-type Mosfet transistors (8, 9) which are powered with a floating voltage, said processing unit (2) is configured to generate said control signal (V) as an AC voltage PWM signal, to control said floating voltage between the gate and the source of said two Mosfet transistors (8, 9) to thereby switch said first electronic switch (6) into said open configuration and said closed configuration,
- said second electronic switch (7) comprises a N-type Mosfet transistor (10) which is powered with a DC voltage, said processing unit (2) is configured to generate said control signal (V) as a DC voltage signal, to cause said second electronic switch (7) to switch between said open configuration and said closed configuration.

3. An electronic apparatus (1) as claimed in claim 2, wherein said first electronic switch (6) comprises a charge pump (11) in signal communication with said processing unit (2), said processing unit (2) is configured to generate said control signal (V) as a PWM signal with such a preset duty cycle frequency that the voltage Vgs between the gate and source electrodes of said two antiserially-connected Mosfet transistors (8, 9) will be at least 2.5 V, to cause said first electronic switch (6) to switch to said closed configuration.

4. An electronic apparatus (1) as claimed in claim 3, wherein said processing unit (2) is configured to generate said control signal (V) as a PWM signal with a duty cycle frequency of at least 10%.

5. An electronic apparatus (1) as claimed in claim 3 or 4, wherein said processing unit (2) is configured to generate said control signal (V) as a PWM signal such that the voltage Vgs between the gate and source electrodes of said two antiserially-connected Mosfet transistors (8, 9) will be 0 V, to switch said first electronic switch (6) to said open configuration.

6. An electronic apparatus (1) as claimed in any of claims 3 to 5, wherein said processing unit (2) comprises a microcontroller which is configured to generate said control signal (V) as a PWM signal at a preset frequency of at least 100 kHz to control said charge pump (11) that will generate said floating voltage, so that the voltage between the gate and the source of said two Mosfet transistors (8, 9) will be at least 2.5 V.

7. An electronic apparatus (1) as claimed in any of claims 3 to 6, wherein said charge pump (11) comprises a capacitor (12) having one end electrically connected with said processing unit (2) to receive said control signal (V), said charge pump (11) comprises two serially-connected diodes (13, 14) wherein the joined end of said two diodes (13, 14) is electrically connected with the other end of said capacitor (12), the other end of a first of the two diodes (13) is electrically connected with the gates of said two Mosfet transistors (8, 9) and the other end of the second of said two diodes (14) is electrically connected with the sources of said two Mosfet transistors (8, 9), said charge pump (11) comprises a resistor (15) connected in parallel to the series of said two diodes (13, 14) and having one end electrically connected with the gates of said two Mosfet transistors (8, 9) and the other end electrically connected with the sources of said two Mosfet transistors (8, 9).

8. An electronic apparatus (1) as claimed in any of claims 3 to 7, wherein
- said second electronic switch (7) comprises a RC circuit (16), which is configured to filter said DC voltage control signal (V) to generate an average value of DC voltage to be provided to said Mosfet transistor (10) of said second electronic switch (7), said second electronic switch (7) being configured to switch to said open configuration when said average voltage value is below a predetermined threshold associated with said Mosfet transistor (10) and is configured to switch to said closed configuration when said average voltage value is above said threshold value.

9. An electronic apparatus (1) as claimed in claim 8, wherein said RC circuit (16) is a low-pass filter.

10. A device for measuring electric quantities of an electric network comprising an electronic apparatus (1) as claimed in any of the preceding claims.
